# EUROPÄISCHE PATENTSCHRIFT

(11) **EP 2 697 823 B1**
(45) Veröffentlichungstag und Bekanntmachung des Hinweises auf die Patenterteilung: **25.06.2014**
(21) Anmeldenummer: 11713301.7
(22) Anmeldetag: 11.04.2011
(51) Int. Cl.: H01L 21/67, H01L 21/687, H01L 21/683, B32B 43/00

(54) **BIEGSAME TRÄGERHALTERUNG, VORRICHTUNG UND VERFAHREN ZUM LÖSEN EINES TRÄGERSUBSTRATS**
BENDABLE CARRIER MOUNTING, DEVICE AND METHOD FOR RELEASING A CARRIER SUBSTRATE
ÉLÉMENT DE MAINTIEN DE SUPPORT FLEXIBLE, DISPOSITIF ET PROCÉDÉ PERMETTANT DE DÉTACHER UN SUBSTRAT DE SUPPORT

(43) Veröffentlichungstag der Anmeldung: 19.02.2014
(73) Patentinhaber: Ev Group E. Thallner GmbH, 4782 St. Florian am Inn (AT)
(72) Erfinder: BURGGRAF, Jürgen, A-4780 Schärding (AT); BURGSTALLER, Daniel, A-4912 Neuhofen im Innkreis (AT)
(74) Vertreter: Becker, Thomas
(86) Internationale Anmeldenummer: PCT/EP2011/055630
(87) Internationale Veröffentlichungsnummer: WO 2012/139627

(56) Entgegenhaltungen:
- DE-A1-102008 018 536
- FR-A1- 2 783 970
- US-A1- 2009 314 430

## Beschreibung

Die Erfindung betrifft eine biegsame Trägerhalterung gemäß Patentanspruch 1, eine Vorrichtung zum Lösen eines Trägersubstrats von einem Produktsubstrat in einer Löserichtung L gemäß Patentanspruch 2, ein korrespondierendes Verfahren gemäß Patentanspruch 9 und eine Verwendung einer biegsamen Trägerhalterung zur Halterung eines Trägersubstrats beim Ablösen des Trägersubstrats von einem Produktsubstrat gemäß Patentanspruch 10.

In der Halbleiterindustrie werden Strukturwafer beziehungsweise Produktwafer häufig temporär auf Trägerwafer beziehungsweise Trägersubstrate gebondet, um sie handhaben zu können. Nach Prozessierung der Produktsubstrate sollen diese möglichst einfach, schnell und kostengünstig sowie sauber von dem Trägersubstrat entfernt werden. Das am häufigsten eingesetzte Verfahren zum Bonden von Produktwafern auf einem Trägerwafer ist die Aufbringung einer Adhäsionsschicht auf einem der beiden Substrate (oder beiden Substraten) und Kontaktierung unter Druck. Beim Ablösen (Debonding) wird der Trägerwafer nach Reduzierung der Adhäsionskraft des Klebers (Temperatur, UV-Strahlung etc.) vom Produktwafer abgelöst, beispielsweise durch paralleles Verschieben der Wafer gegeneinander. Die Wafer werden dabei durch sogenannte Chucks durch Unterdruck gehalten.

Dokument DE 10 2008 018536 etwa zeigt eine Trägerhalterung, die beim Lösen eines Trägersubstrats von einem Produktsubstrat einsetzbar ist.

Beim Debonden sind eine Vielzahl kritischer Faktoren zu berücksichtigen und oberste Priorität besteht darin, den brüchigen und auf Grund der Vorbearbeitung sehr teuren Produktwafer möglichst geringem Stress auszusetzen und diesen nicht zu beschädigen. Das Ablösen des Trägersubstrats soll auf der anderen Seite kostengünstig und schnell mit geringst möglichem Energieaufwand erfolgen. Bei einer Vielzahl von bekannten Ablöseprozessen ist es erforderlich, insbesondere zur Auflösung der Adhäsionseigenschaften der Adhäsionsschicht zwischen den Wafern, den "Stack" (Stapel) aus Trägerwafer und Strukturwafer/Produktwafer auf eine für den Kleber spezifische Temperatur aufzuheizen.

Aufgabe der vorliegenden Erfindung ist es daher, die gattungsgemäßen Vorrichtungen und Verfahren zum Ablösen von Trägersubstraten derart weiterzubilden, dass ein schonendes und gleichzeitig deutlich schnelleres Ablösen ermöglicht wird. Gleichzeitig soll der Energieverbrauch reduziert werden.

Diese Aufgabe wird mit den Merkmalen der Patentansprüche 1, 9 und 10 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Zeichnungen angegebenen Merkmalen. Bei Wertebereichen sollen auch innerhalb der genannten Grenzen liegende Werte als Grenzwerte offenbart und in beliebiger Kombination beanspruchbar sein.

Grundgedanke der vorliegenden Erfindung ist es, eine Trägerhalterung zur Halterung des Trägersubstrats beim Lösen des Trägersubstrats von dem Produktsubstrat so zu konstruieren, dass die Trägerhalterung eine Biegung des Trägersubstrats zulassend ausgebildet ist. Die Trägerhalterung weist erfindungsgemäß eine ausreichende Biegesteifigkeit auf, um eine Lösekraft zum Ablösen des Trägersubstrats vom Produktsubstrat zu bewirken, insbesondere durch Abheben vom Rand des Trägersubstrats her.

Erfindungsgemäß soll dabei nur eine leichte Durchbiegung, insbesondere < 45° Biegewinkel, vorzugsweise < 40°, noch bevorzugter < 30°, besonders bevorzugt < 20°, mit noch größerem Vorzug < 10°, mit allergrößtem Vorzug < 5°, erfolgen. Auf diese Weise wird das auch eine gewisse, insbesondere der Trägerhalterung ähnliche, Biegesteifigkeit aufweisende Trägersubstrat und vor allen Dingen das Produktsubstrat vor Beschädigung geschützt. Durch die Biegung wirkt der größte Teil der Lösekraft an der wandernden Lösefront, die insbesondere vom Rand des Trägersubstrats her in Richtung des Zentrums wandert.

Kern der Erfindung ist daher eine biegsame Trägerhalterung zur Halterung eines Trägersubstrats beim Lösen des Trägersubstrats von einem Produktsubstrat, wobei Lösemittel zum Ablösen des Produktsubstrats unter Biegung des Trägersubstrats an der Trägerhalterung vorgesehen sind.

Erfindungsgemäß denkbar sind also auch vollflächige, nicht ringförmige Ausführungen der Trägerhalterung, insbesondere aus Polymer mit einer gewissen Elastizität beziehungsweise Biegesteifigkeit. Diese würden zur Fixierung und Aufnahme des Trägersubstrats Vakuumdurchgänge aufweisen. Hierbei kann, insbesondere zusätzlich, zur Erhöhung der Haltekraft, eine elektrostatische Fixierung des Trägersubstrats an der Trägerhalterung vorgesehen sein.
Die Trägerhalterung kann auch zumindest teilweise aus Metall, Keramik oder einem Verbundwerkstoff bestehen. Die verwendeten Materialien müssen nur die erfindungsgemäße Funktionalität erlauben.

Als eigenständige Erfindung ist außerdem eine Vorrichtung zum Lösen eines Trägersubstrats von einem Produktsubstrat in einer Löserichtung L mit folgenden Merkmalen vorgesehen:
- einer in Löserichtung L biegsamen Trägerhalterung zur Halterung des Trägersubstrats,
- einer Substrathalterung zur Halterung des Produktsubstrats und
- Lösemitteln zum Ablösen des Trägersubstrats vom Produktsubstrat unter Biegung des Trägersubstrats.

Die Löserichtung L ist erfindungsgemäß im Wesentlichen, insbesondere genau, normal zur Oberfläche des Trägersubstrats und/oder Produktsubstrats. Eine Biegeachse der Biegung der Trägerhalterung und/oder des von der Trägerhalterung aufgenommenen Trägersubstrats ist normal zur Löserichtung L. Die Biegeachse liegt insbesondere parallel zur Oberfläche des Produktsubstrats und/oder des Trägersubstrats.

Die erfindungsgemäße Vorrichtung kann in vorteilhafter Ausführung eine Druckkammer umfassen, die mit Überdruck beaufschlagbar ist, um einen mit Unterdruck an der Trägerhalterung fixiertes Trägersubstrat noch stärker an diesem zu fixieren. Der Druck in der Kammer kann dabei > 1 bar, mit Vorzug > 2 bar, mit noch größerem Vorzug > 5 bar, mit noch größerem Vorzug > 10 bar, insbesondere kleiner 100 bar, sein.

Gemäß einer vorteilhaften Ausführungsform der Erfindung ist vorgesehen, dass die Trägerhalterung in Löserichtung L elastisch verformbar ist. Durch die Elastizität der Trägerhalterung wird es erfindungsgemäß ermöglicht, die Lösekraft jeweils an der wandernden Lösefront zu konzentrieren, obwohl eine Zugkraft nur am Umfang des Trägersubstrats angelegt wird.

In einer weiteren vorteilhaften Ausführungsform der Erfindung ist vorgesehen, dass durch die Lösemittel mindestens eine am Umfang der Substrathalterung wirkende Zugkraft und mindestens eine entgegen der Zugkraft am Umfang der Trägerhalterung wirkende Gegenkraft zur Erzeugung von Lösemomenten entlang einer Lösefront anlegbar sind. Hierdurch kann die Gesamtbelastung, insbesondere beim Beginn des Ablösens, reduziert werden. Auf diese Weise wird eine noch stärkere Schonung des Träger- und des Produktsubstrats bewirkt. Es ist dabei insbesondere vorgesehen, dass die Zugkräfte sich, insbesondere durch gleichmäßige Aufbringung von Zugkräften am Umfang der Substrathalterung, zu einer resultierenden Zugkraft im Zentrum der Substrathalterung summieren, während sich die Gegenkraft oder die Gegenkräfte zu einer resultierenden Gegenkraft an einem Rand der Trägerhalterung sowie entsprechenden Lösemomenten an der wandernden Lösefront summieren. Die Trägerhalterung wird demnach gegenüber der Substrathalterung gekippt.

Zur noch stärkeren Schonung des Produktsubstrats, insbesondere bei sehr empfindlichen oder sehr teuren Produktsubstraten, ist es erfindungsgemäß vorgesehen, die Substrathalterung als starre, insbesondere das Produktsubstrat vollflächig aufnehmende, Aufnahme auszubilden.

Gemäß einer weiteren vorteilhaften Ausführungsform der Erfindung ist vorgesehen, die Trägerhalterung als, insbesondere offener, Ring mit verstellbarem Innendurchmesser Dᵢ auszubilden. Durch die Ringform lässt sich die Biegesteifigkeit auch durch die Ringgeometrie, insbesondere die Ringbreite B zum Ringdurchmesser Dₐ und/oder zur Höhe H des Rings optimal auf das Trägersubstrat einstellen. Die Ringform bewirkt weiterhin, dass im Bereich der Ringöffnung eine stärkere Bewegungsfreiheit des Trägersubstrats zugelassen wird, so dass ein Zusammenwirken der Biegesteifigkeit der Trägerhalterung und der Biegesteifigkeit des Trägersubstrats erreicht wird. Dabei ist die Biegesteifigkeit der Trägerhalterung insbesondere mindestens gleich oder höher als die Biegesteifigkeit des Trägersubstrats.

Die Biegesteifigkeit der Trägerhalterung ist mit Vorteil erfindungsgemäß derart gewählt, dass diese in einem Bereich zwischen 1/20 bis 20 mal, insbesondere zwischen 1/10 bis 10 mal, vorzugsweise zwischen 1/5 bis 5 mal, noch bevorzugter zwischen ½ bis 2 mal, der Biegesteifigkeit des Trägersubstrats liegt. Als Trägersubstrat kommt insbesondere ein Wafer aus Silizium mit einer Dicke d zwischen 500µm und 750µm, vorzugsweise von 600µm, in Frage. Dieser kann einen Durchmesser Dₜ von 200 mm oder 300 mm aufweisen.

Dabei ist es von besonderem Vorteil, insbesondere über den gesamten Ringumfang verlaufende, Haltemittel, insbesondere in Form einer zurückspringenden Umfangsschulter, vorzusehen. Somit kann mit einer einfachen geometrischen Form, die kostengünstig herstellbar ist, sowohl die Lösekraft auf das Trägersubstrat, insbesondere am gesamten Umfang des Trägersubstrats, aufgebracht werden und die besonders kritische Initiierung der Lösefront beim Beginn des Ablösens an eine oder mehrere Stellen am Umfang des Trägersubstarts konzentriert werden.

In Weiterbildung ist es erfindungsgemäß vorgesehen, dass die Trägerhalterung das Trägersubstrat im Wesentlichen vollständig, insbesondere mindestens zu 98% des Umfangs, vorzugsweise mindestens zu 99%, noch bevorzugter zu mindestens 99,5%, seitlich umschließend ausgebildet ist. Hierdurch wird das Trägersubstrat quasi vollumfänglich gestützt. Die Trägerhalterung ist insbesondere als, vorzugsweise mindestens zu 98% des Umfangs, noch bevorzugter mindestens zu 99%, noch bevorzugter zu mindestens 99,5%, umfangsgeschlossener Ring ausgebildet. Der Ring kann auch aus Einzelsegmenten zusammengesetzt sein.

Gemäß einer vorteilhaften Ausführungsform weisen die Lösemittel translatorische Antriebsmittel zur Bewirkung einer Translationsbewegung mindestens eines Umfangsabschnitts der Trägerhalterung in Löserichtung L auf.

Als eigenständige Erfindung ist ein Verfahren zum Lösen eines Trägersubstrats von einem Produktsubstrat in einer Löserichtung L mit folgenden Schritten, insbesondere folgendem Ablauf, vorgesehen:
- Halterung des Produktsubstrats mit einer Substrathalterung und Halterung des Trägersubstrats mit einer in Löserichtung L biegsamen Trägerhalterung und
- Ablösen des Trägersubstrats vom Produktsubstrat unter Biegung des Trägersubstrats.

Weiterhin ist erfindungsgemäß eine Verwendung einer biegsamen Trägerhalterung zur Halterung eines Trägersubstrats beim Ablösen des Trägersubstrats von einem Produktsubstrat vorgesehen.

In vorteilhafter Ausführungsform der Erfindung ist vorgesehen, dass das Ablösen bei einer Temperatur < 200°C, vorzugsweise < 100°C, noch bevorzugter < 50°C, idealerweise bei Umgebungstemperatur, insbesondere ohne vollflächige Aufheizmittel, erfolgt.

Erfindungsgemäß ist es denkbar, das Ablösen, insbesondere an der Lösefront, zu beschleunigen, indem lokal auf die Lösefront durch die Lösemittel eingewirkt wird, insbesondere durch Trennungsmittel. Die Trennungsmittel können mechanisches Trennen und/oder lokales Aufheizen, vorzugsweise einen gerichteten Heizluftstrom umfassen. Konkret können ein Trennkeil, eine Trennklinge, ein Trenndraht oder ein auf die Lösefront gerichteter, vorzugsweise warmer, Druckluftstrahl einzeln oder kombiniert vorgesehen sein.
Unter einem Trennkeil versteht man ein Werkzeug mit vorzugsweise v-förmigem Profil. Unter einer Trennklinge versteht man ein Werkzeug mit einer extrem scharfen Kante. Der Trenndraht ist ein sehr dünner, mit Vorzug hochfester Draht, welcher durch eine entsprechende Apparatur im gespannten Zustand in der Ebene der Zwischenschicht auf sie zu verschoben wird. Der Trenndraht ist insbesondere als Heizdraht, also beheizbar ausgebildet.

Erfindungsgemäß ist auch eine Ausführungsform denkbar, bei der die Lösefront quasi spiralförmig während des Lösens entlang des Umfangs des Produktsubstrats nach innen zum Zentrum verläuft. Dies wird erreicht, indem die am Umfang wirkenden Lösekräfte am Umfang umlaufend gesteigert werden.

Für die erfindungsgemäße Vorrichtung und das erfindungsgemäße Verfahren sowie die erfindungsgemäße Verwendung gelten die beschriebenen Merkmale analog.

Weitere Vorteile, Merkmale und Einzelheiten der Erfindung ergeben sich aus der Beschreibung bevorzugter Ausführungsbeispiele sowie anhand der Zeichnungen. Diese zeigen in:
- Figur 1: eine Aufsicht auf eine erfindungsgemäße Trägerhalterung mit einer Schnittlinie A-A,
- Figur 2: eine Querschnittsansicht der Trägerhalterung gemäß Schnittlinie A-A aus Figur 1,
- Figur 3: eine Ansicht der Trägerhalterung gemäß Figur 1 von unten,
- Figur 4: eine Detailansicht des Details E aus Figur 2,

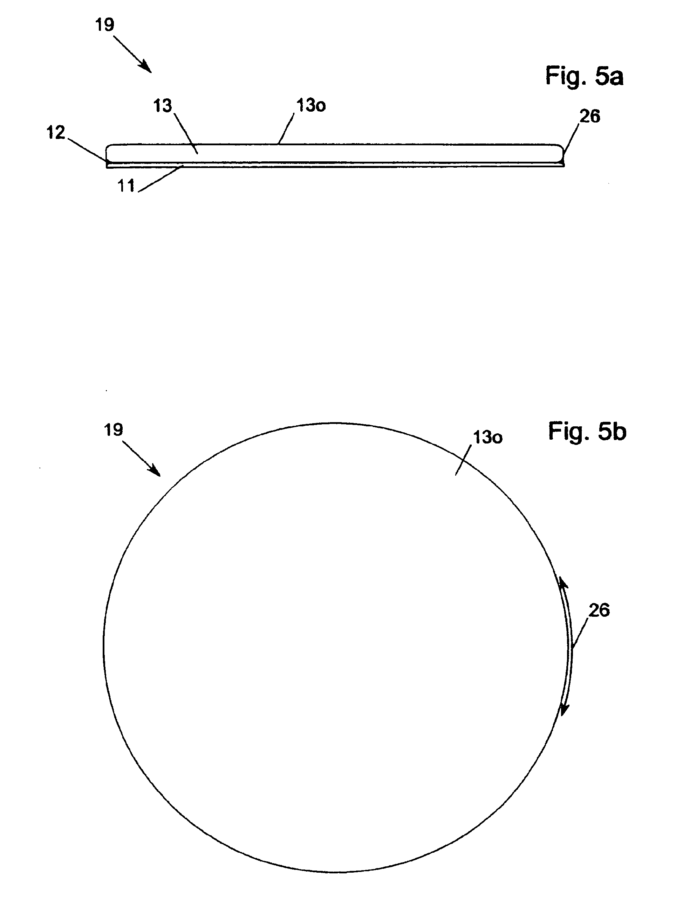

- Figur 5a: eine Seitenansicht eines Stacks aus Trägersubstrat, Verbindungsschicht und Produktsubstrat,
- Figur 5b: eine Aufsicht eines Stacks aus Trägersubstrat, Verbindungsschicht und Produktsubstrat,
- Figur 6: eine Detailansicht analog Figur 4 mit einer ersten Ausführungsform der Trägerhalterung,
- Figur 7: eine Detailansicht analog Figur 4 mit einer zweiten Ausführungsform der Trägerhalterung,
- Figur 8: ein auf einem Filmrahmen festgelegter Stack,
- Figuren 9a - 9d: eine erfindungsgemäße Vorrichtung gemäß einer ersten Ausführungsform mit vier erfindungsgemäßen Verfahrensschritten und
- Figuren 10a - 10d: eine zweite Ausführungsform der erfindungsgemäßen Vorrichtung mit vier Verfahrensschritten.

In den Figuren sind gleiche oder gleichwirkende Bauteile mit den gleichen Bezugszeichen gekennzeichnet.

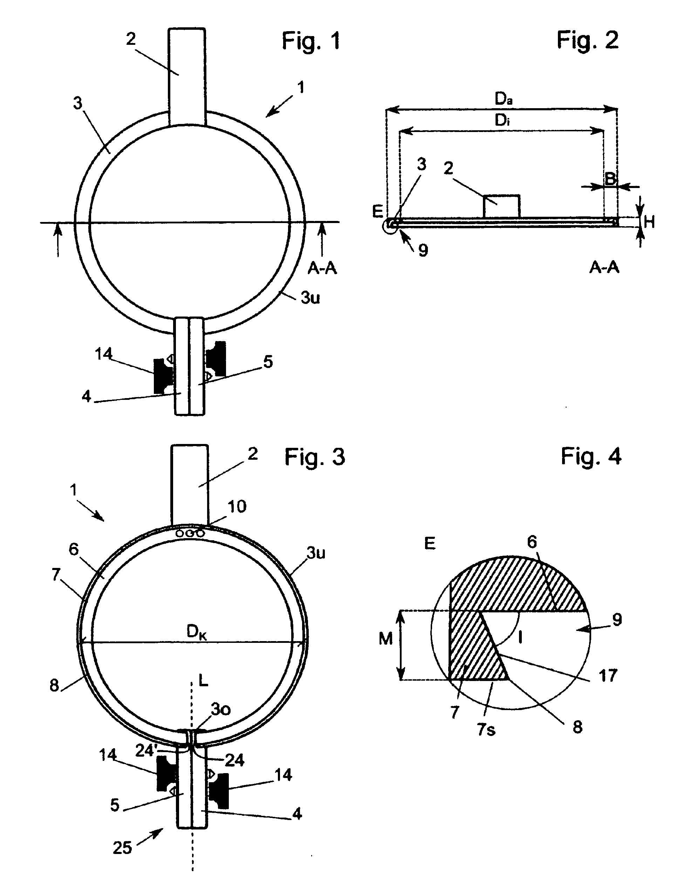

Figur 1 zeigt eine halbautomatisch einsetzbare Trägerhalterung 1, bei der die Aufnahme eines Trägersubstrats 13 durch die Trägerhalterung 1 manuell erfolgt. Die Trägerhalterung 1 dient zum Ablösen des Trägersubstrats 13 von einem durch eine Verbindungsschicht 12 mit dem Trägersubstrat verbundenen Produktsubstrat 11.

Die Trägerhalterung 1 besteht aus einem an einem Umfangsabschnitt 26 angeordneten Haltegriff 2 und einem gegenüberliegend zum Haltegriff 2 geöffneten Ring 3. An der Öffnung 3o des Rings 3 sind jeweils an den sich gegenüberliegenden Enden 24, 24' des Rings 3 Abstandsmittel 25 zur Einstellung eines Abstands A zwischen den Enden 24, 24' vorgesehen. Durch die Einstellung des Abstands A sind ein innerer Durchmesser Dᵢ und ein äußerer Durchmesser Dₐ des Rings 3 einstellbar. Die Abstandsmittel 25 bestehen im vorliegenden Ausführungsbeispiel aus Hebeln 4, 5, wobei der Hebel 4 an dem Ende 24 und der Hebel 5 an dem Ende 24' eingebracht sind. Die Hebel 4, 5 sind von Stellelementen 14 durchsetzt, die hier manuell bedienbar sind. Eine automatische Umsetzung der vorbeschriebenen manuellen Kinematik ist erfindungsgemäß denkbar.

Die Befestigung des Haltegriffs 2 am Ring 3 erfolgt durch Fixierelemente 10, insbesondere Schrauben. Das Material des Rings 3 ist erfindungsgemäß bei vorgegebener Geometrie (Ringhöhe H, Ringbreite B, Außendurchmesser Dₐ, Innendurchmesser Dᵢ) so zu wählen, dass der Ring 3 sich durch die Abstandsmittel 25 elastisch verbiegen lässt, und zwar entgegen seiner durch die Biegesteifigkeit bewirkten Kraft.

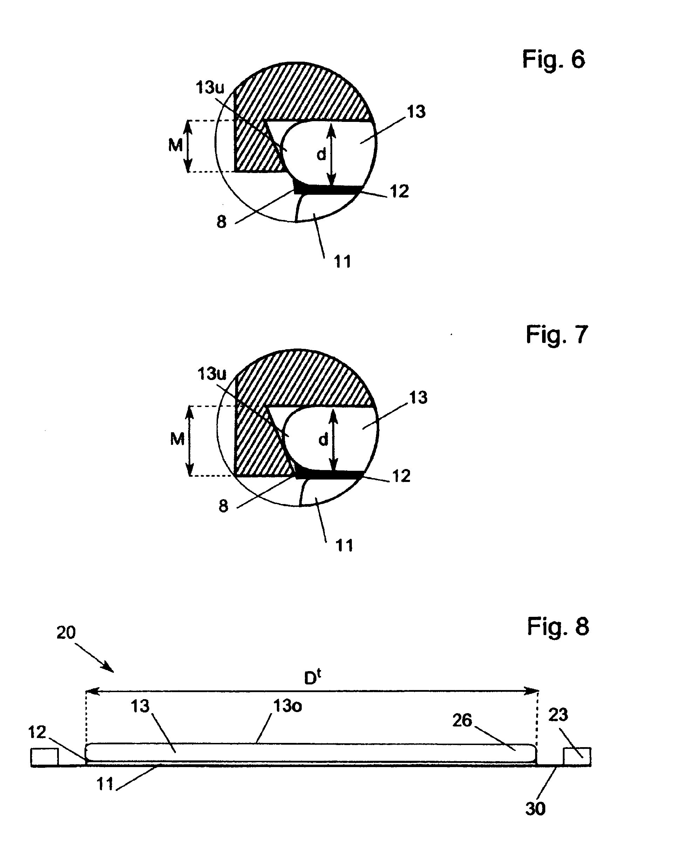

Der Ring 3 weist eine Umfangsschulter 7 auf, die von einem Ringabsatz 6 absteht und eine Stufe 9 bildet. Die Stufe 9 verläuft z-förmig mit einem zur Ringmitte gerichteten Innenwinkel 45° < I < 90°, insbesondere < 80°, vorzugsweise < 70° und bildet dadurch eine, insbesondere umlaufende, Wandschräge 17, die an einer spitzen Innenkante 8 endet. Die Innenkante 8 ist gleichzeitig Bestandteil einer parallel zum Ringabsatz 6 verlaufenden Stirnfläche 7s der Umfangsschulter 7. Die Stirnfläche 7s ist äquidistant zu dem Ringabsatz 6 mit einem Abstand M. Der Abstand M ist erfindungsgemäß so gewählt, dass er maximal geringfügig größer, insbesondere maximal um die Dicke der Verbindungsschicht 12 größer, als eine Dicke d des Trägersubstrats 13 ist (siehe Figur 7). Vorzugsweise ist der Abstand M wie in Figur 6 so gewählt, dass er kleiner als die Dicke d des Trägersubstrats 13 ist. Vorzugsweise ist der Abstand M mindestens halb so groß wie die Dicke d des Trägersubstrats 13.

Durch die Abstandsmittel 25 lässt sich ein durch die Innenkante 8 gebildeter, zwischen dem Innendurchmesser Dᵢ und dem Außendurchmesser Dₐ liegender, Durchmesser Dₖ zur Aufnahme des Trägersubstrats 13 vergrößern, bis das Trägersubstrat 13 durch eine durch die Innenkante 8 gebildete Öffnung (Durchmesser Dₖ) bis zum Ringabsatz 6 einsetzbar ist. Anschließend wird durch die Abstandsmittel 25 der Durchmesser Dₖ wieder verringert, bis eine Umfangskante 13u des Trägersubstrats 13 an der Schräge 17 der Umfangsschulter 7 anliegt und durch diese fixiert wird. Somit ist das Trägersubstrat 13 von der biegsamen Trägerhalterung 1 gehalten. Die Halterung erfolgt quasi durch Klemmung und/oder Formschluss. Bei Klemmung des Trägersubstrats 13 an der Schräge 17 können Kraftmessmittel zur Steuerung der Einklemmung vorgesehen sein, insbesondere an den Stellmitteln 14.

Das Produktsubstrat 11 ist nur über die Verbindungsschicht 12 an der Trägerhalterung befestigt. Ein direkter Kontakt zwischen der Trägerhalterung 1 und dem Produktsubstrat 11 ist nicht vorgesehen. Bei Vermeidung eines Kontakts zwischen der Trägerhalterung 1 und dem Produktsubstrat 11 wird das Produktsubstrat 11 maximal geschont und eine Kontamination oder Beschädigung praktisch ausgeschlossen.

Das Produktsubstrat 11 bildet mit der Verbindungsschicht 12 und dem Trägersubstrat 13 einen Stack 19 (Trägersubstrat - Produktsubstrat - Verbund). Ebenso ist die vorliegende Erfindung geeignet für einen Verbund aus Trägersubstrat und Produktsubstrat ohne dzwischenliegende Verbindungsschicht, insbesondere bei sogennnten Pre-Bonds, bei welchen die Wafer insbesondere mittels Van-der-Waals-Kräften aneinander haften.

Die spitze Innenkante 8 dient bei der Fixierung des Stacks 19 an der Trägerhalterung 1 in der in Figur 7 gezeigten Ausführungsform gleichzeitig als Trennmittel beziehungsweise zur Initiierung des Ablösens, indem die Spitze der Innenkante 8 an der Umfangskante der Verbindungsschicht 12 in die Verbindungsschicht 12 eindringt.

Die Trägerhalterung 1 umschließt das Trägersubstrat 13 praktisch vollständig, mit Ausnahme der Ringöffnung 3o.

Figur 8 zeigt den Stack 19 auf einem Filmrahmen 23, wobei das Produktsubstrat 11 mit einer mit dem Filmrahmen 23 verbundenen Folie 21 verbunden ist. Der Stack 19, der Filmrahmen 23 und der Folie 21 einen Filmrahmenverbund 20.

Mittels des Haltegriffs 2 und durch Fixierung des Produktsubstrats 11 oder des Filmrahmens 23 ist das Trägersubstrat 13 von dem Produktsubstrat 11 abziehbar. Die Zugkraft wird dabei durch die einseitige Anordnung des Haltegriffs 2 seitlich an dem Trägersubstrat 13, also an dem Umfangsabschnitt 26, aufgebracht. Initiiert durch das Eindringen der Innenkante 8 in die Verbindungsschicht 12 wird das Trägersubstrat 13 unter Verformung des Trägersubstrats 13 und des Rings 3 (entgegen deren durch die Biegesteifigkeit erzeugten Kraft) ausgehend von dem Umfangsabschnitt 26 zur gegenüberliegenden Seite langsam abgelöst. Dabei wandert eine Lösefront von dem Umfangsabschnitt 26 bis zur gegenüberliegenden Seite des Trägersubstrats 13 durch die Verbindungsschicht 12. Entlang der Lösefront wirken demnach je nach Abstand der Lösefront vom Haltegriff 2 und der am Haltegriff 2 angelegten Lösekraft definierte Drehmomente.

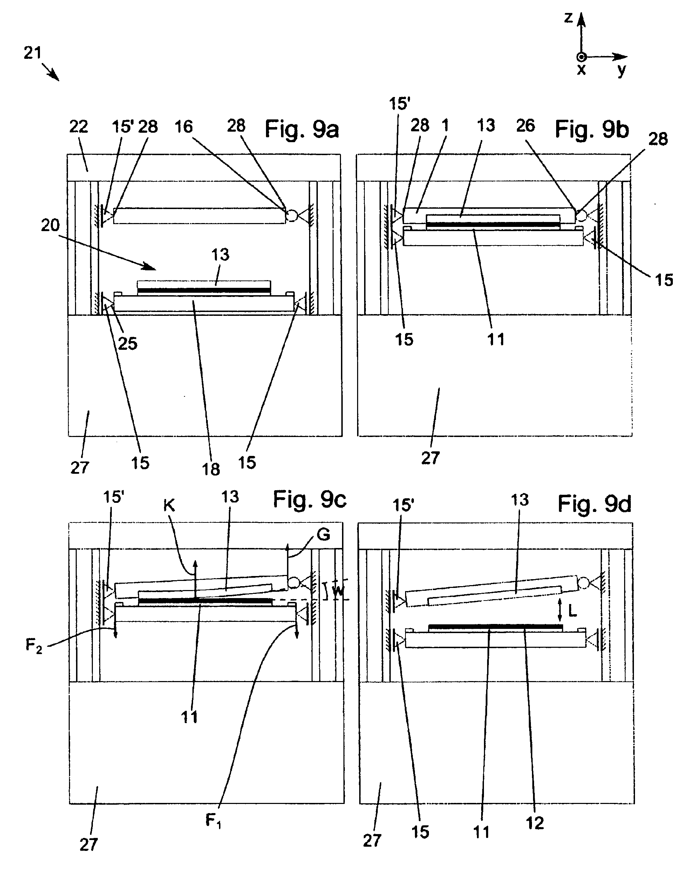

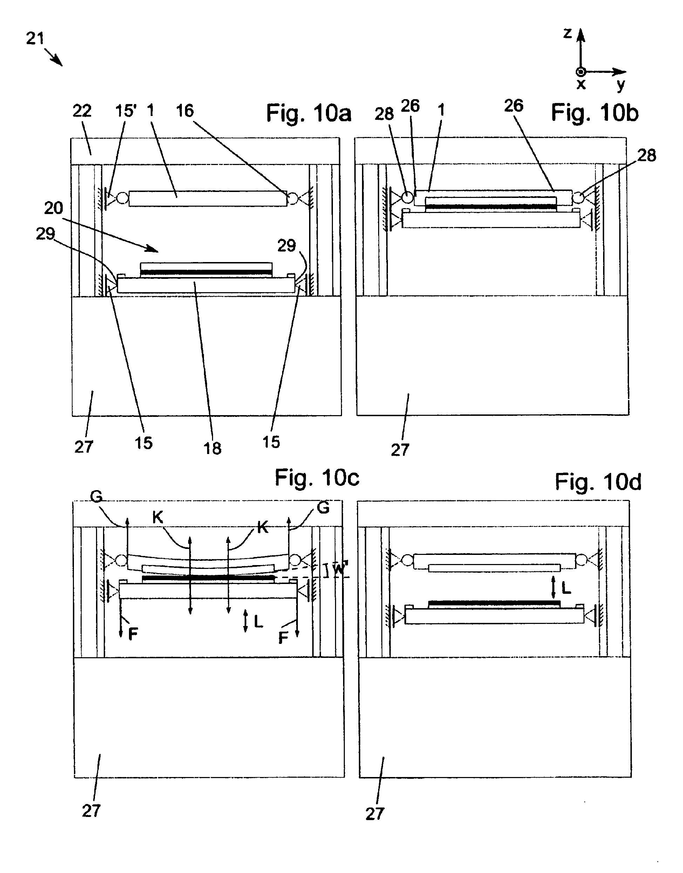

In automatisierter Form ist dies in den Figuren 9a bis 9d in einer ersten Ausführungsform und in den Figuren 10a bis 10d in einer zweiten Ausführungsform gezeigt, die nachfolgend näher beschrieben werden.

Den beiden Ausführungsformen gemein ist die Verwendung der oben beschriebenen Trägerhalterung 1 zur Halterung des Trägersubstrats 13 in einer zur Automatisierung geeigneten Form.

Ein wesentlicher Erfindungsaspekt besteht darin, beim Beginn des Ablösens, also bei der Initiierung des Ablösens, eine besonders schonende Behandlung vorzusehen, insbesondere durch Implementierung einer mechanischen Anlösung der Verbindungsschicht am Umfang beziehungsweise an deren Rand.

In den Figuren 9 und 10 sind jeweils eine Basis 27 und ein darauf aufbauendes Gestell 22 zur Vorsehung einer stabilen Grundkonstruktion und Befestigung weiterer, unten beschriebener Bauteile der erfindungsgemäßen Vorrichtung gezeigt. An dem Gestell 22 und/oder der Basis 27, insbesondere zwischen einem Deckel 22d des Gestells 22 und einem durch die Basis 27 gebildeten Boden 27b, sind Antriebsmittel 15' zur translatorischen Bewegung (insbesondere angetrieben) der Trägerhalterung 1 beziehungsweise von Umfangsabschnitten der Trägerhalterung 1 sowie Antriebsmittel 15 zur translatorischen Bewegung (insbesondere angetrieben) einer den Stack 19 oder den Filmrahmenverbund 20 aufnehmenden Substrathalterung 18 (Aufnahme) vorgesehen. Die Antriebsmittel 15' können einen Freilauf in Translationsrichtung aufweisen, insbesondere gebildet durch ein Loslager.

Die Substrathalterung 18 ist bei beiden Ausführungsformen gemäß Figur 9 und Figur 10 in einer Löserichtung L, also in der Zeichnungsebene nach oben und/oder unten translatorisch bewegbar. Die Antriebsmittel 15 zum Antreiben der Substrathalterung 18 können dabei insbesondere synchron bewegt werden, vorzugsweise angetrieben durch von einer zentralen Steuereinrichtung gesteuerte Motoren, insbesondere Schrittmotoren.

In der Ausführungsform gemäß Figur 9 ist für die Trägerhalterung 1 nur ein Antriebsmittel 15' an der zum Umfangsabschnitt 26 gegenüberliegenden Seite der Trägerhalterung 1 vorgesehen, während am Umfangsabschnitt 26 ein Gelenklager 16 vorgesehen ist, so dass die Trägerhalterung um das Gelenklager 16 schwenkbar ist, jedoch in Löserichtung L fixiert ist. Somit ergibt sich folgender Verfahrensablauf:

In dem in Figur 9a gezeigten Verfahrensschritt wird die für den Filmrahmenverbund 20, insbesondere das Trägersubstrat 13, passende Trägerhalterung 1 an dem oberen Antriebsmittel 15' und dem Gelenklager 16 angebracht. Gleichzeitig, vorher oder anschließend wird der Filmrahmenverbund 20 auf die Substrathalterung 18 fixiert, insbesondere durch Vakuumbeaufschlagung. Die Substrathalterung 18 ist durch die Antriebsmittel 15 in Löserichtung L bewegbar.

Erfindungsgemäß ist des dabei alternativ denkbar, dass am Umfang der Trägerhalterung 1 mehrere, insbesondere zwei, Antriebsmittel 15' an einer Seite und mehrere, insbesondere zwei, Gelenklager 16 an der gegenüberliegenden Seite, vorgesehen sind.

Die Trägerhalterung 1 ist jeweils durch am Ringumfang 3u angeordnete Haltemittel 28 an dem Antriebsmittel 15' und dem Gelenklager 16 fixierbar. Die Substrathalterung 18 ist durch Haltemittel 29 an den Antriebsmitteln 15 fixierbar.

Anschließend wird die Substrathalterung 18 in die in Figur 9b gezeigte Position (also in Löserichtung L zu der Trägerhalterung 1 hin) verfahren, indem die Antriebsmittel 15 eine synchrone Translationsbewegung der Substrathalterung 18 ausführen, bis das Trägersubstrat 13 mit seiner Oberseite 13o an dem Ringabsatz 6 anliegt. Die Steuerung kann über die zentrale Steuereinrichtung erfolgen, wobei die Erkennung des Auftreffens des Trägersubstrats 13 auf den Ringabsatz 6 durch, insbesondere in die Substrataufnahme 18 integrierte, Kraftmessmittel erfolgt. Vorzugsweise sind am Umfang der Substrataufnahme 18 eine Anzahl n Kraftmessdosen in einem Winkelabstand von 360°/n verteilt angeordnet.

Damit das Trägersubstrat 13 in der Trägerhalterung 1 aufnehmbar ist, muss vorher der Durchmesser Dₖ an der Innenkante 8 des Rings 3 entsprechend angepasst werden, damit das Trägersubstrat 13 mit seiner Außenkontur (insbesondere kreisförmig mit einem Durchmesser Dₜ) in die Trägerhalterung 1 aufnehmbar ist. Der Innendurchmesser Dᵢ ist bei der Aufnahme des Trägersubstrats 13 kleiner als der Durchmesser Dₜ des Trägersubstrats 13, damit das Trägersubstrat 13 nicht durchrutscht. Sobald die in Figur 9b gezeigte Position erreicht ist, kann der Innendurchmesser Dᵢ verringert werden, bis das Trägersubstrat 13 in der Trägerhalterung 1 fixiert ist (siehe Figuren 6 und 7), also an der Wandschräge 17 anliegt.

Sobald die in Figur 9b gezeigte Position erreicht ist, wird das obere, fixierbare Antriebsmittel 15' gelöst, so dass dieses einen Freiheitsgrad in Löserichtung L hat und die an dem Antriebsmittel 15' befestigte Seite der Trägerhalterung 1 in Löserichtung L freibeweglich ist. In dieser Ausführungsform ist das Antriebmittel 15' antriebslos ausgebildet. Erfindungsgemäß denkbar ist aber auch hier eine Steuerung der Bewegung durch die zentrale Steuereinrichtung, so dass das Antriebsmittel 15' nicht passiv (wie in der bevorzugten Ausführungsform), sondern aktiv ausgebildet ist.

Anschließend wird an den beiden gegenüberliegend an der Substrathalterung 18 vorgesehenen Antriebsmitteln 15 auf die Substrathalterung 18 jeweils eine von der Trägerhalterung 1 weg gerichtete Antriebskraft F₁ (Zugkraft) und eine, insbesondere mit der Antriebskraft F₁ identische, Antriebskraft F₂ (Zugkraft), insbesondere synchron, zum Ablösen des an der Trägerhalterung 1 fixierten Trägersubstrats 13 von dem Produktsubstrat 11 angelegt.

Entgegen der Antriebskräfte F₁ und F₂ und insbesondere parallel zu diesen wirkend liegt an dem Gelenklager 16 eine Gegenkraft G (oder mehrere Gegenkräfte G, falls mehrere Gelenklager 16 vorgesehen sind) an.

Hierdurch wird der von der Innenkante 8 initiierte Ablösevorgang fortgesetzt, wobei an der sich vom Gelenklager 16 bis zur gegenüberliegenden Seite der Trägerhalterung 1 eine Lösefront unter zunehmender Biegung der Trägerhalterung 1 und des Trägersubstrats 13 verläuft. Entlang der Lösefront wirken im Gleichgewicht mit den Antriebskräften F₁ und F₂ sowie der (durch die Verbindungskraft der Verbindungsschicht 12 bewirkte) Gegenkraft G Drehmomente als infinitesimal entlang der Lösefront verteilte Lösemomente K₁ bis Kₙ.

In der in Figur 9c gezeigten Position ist das Trägersubstrat 13 zu mehr als der Hälfte abgelöst, wobei die Ablösung erfolgt, indem sich sowohl das Trägersubstrat 13 als auch die Trägerhalterung 1 verformen (entgegen der Biegefestigkeit der Trägerhalterung 1 und des Trägersubstrats 13).

In der in Figur 9d gezeigten Position ist das Trägersubstrat 13 vollständig von dem Produktsubstrat 11 abgelöst. Die Verbindungsschicht 12 haftet in der Darstellung an dem Produktsubstrat 11, kann aber auch teilweise oder vollständig an dem Trägersubstrat 13 anhaften.

Während des Ablösens verbiegt sich die Trägerhalterung 1 und das Trägersubstrat 13 um einen (mittleren, insbesondere gemessen bei halber Ablösung des Trägersubstrats 13 vom Produktsubstrat 11) Biegewinkel 1° < W < 45°, insbesondere W < 35° hier etwa 6°.

In der zweiten Ausführungsform gemäß Figur 10a bis Figur 10d ist statt dem Antriebsmittel 15' ein Gelenklager 16 an der Trägerhalterung 1 vorgesehen, so dass die Trägerhalterung 1 an dem Umfangsabschnitten 26 und einem gegenüberliegenden Umfangsabschnitt 26' (also wo die Gelenklager 16 an Haltemitteln 28 der Trägerhalterung 1 angebracht sind) in Löserichtung L fix sind (Erfindungsgemäß können mehrere Gelenklager 16 am Umfang der Trägerhalterung 1 vorgesehen sein). In Abschnitten zwischen den Umfangsabschnitten 26 ist die Trägerhalterung 1 im Rahmen ihrer Biegsamkeit entgegen der Biegesteifigkeit beweglich. Somit ergibt sich bei Anlegen der Antriebskräfte im Verfahrensschritt gemäß 10c eine im Wesentlichen (gewellt) konzentrisch vom Umfang der Verbindungsschicht 12 verlaufende Lösefront zur Mitte der Verbindungsschicht 12. Dabei spielt die Initiierung durch die Innenkante 8 der Trägerhalterung eine wesentliche Rolle zur Überwindung der anfänglichen Verbindungskraft der Verbindungsschicht 12.

Die Lösemomente Kₗ bis Kₙ wirken bei der Ausführungsform gemäß Figur 10a bis 10d beim Fortschreiten der Lösefront jeweils überwiegend an einem (gewellten) kreisförmigen Abschnitt entlang der Lösefront. Während der Biegungswinkel W gemäß Figur 9c zum Gelenklager gegenüberliegenden Seitenrand gemessen wird, wird der Biegungswinkel W' wegen der von allen Seiten am Umfang wirkenden Lösekraft K vom Zentrum des Trägersubstrats 13 zum Rand gemessen, wobei der Biegungswinkel W' in diesem Fall wegen der geringeren Strecke entsprechend kleiner ist, soweit das Material der Trägerhalterung 1 und des Trägersubstrats 2 sowie deren Abmessungen ansonsten identisch sind. Durch Reduzierung der Ringbreite B und/oder der Ringhöhe H kann die Biegesteifigkeit des Rings 3 reduziert werden, so dass sich der Biegungswinkel W' erhöhen würde.

### Bezugszeichenliste

- 1: Trägerhalterung
- 2: Haltegriff
- 3: Ring
- 3o: Öffnung
- 3u: Ringumfang
- 4: Hebel
- 5: Hebel
- 6: Ringabsatz
- 7: Umfangsschulter
- 7s: Stirnfläche
- 8: Innenkante
- 9: Stufe
- 10: Fixiermittel
- 11: Produktsubstrat
- 12: Verbindungsschicht
- 13: Trägersubstrat
- 13o: Oberseite
- 13u: Umfangskante
- 14: Stellelemente
- 15, 15': Antriebsmittel
- 16: Gelenklager
- 17: Schräge
- 18: Substrathalterung
- 19: Stack
- 20: Filmrahmenverbund
- 21: Folie
- 22: Gestell
- 22d: Deckel
- 23: Filmrahmen
- 24, 24': Enden
- 25: Abstandsmittel
- 26: Umfangsabschnitt
- 27: Basis
- 27b: Boden
- 28: Haltemittel
- 29: Haltemittel
- A: Abstand
- B: Ringbreite
- Dᵢ: Innendurchmesser
- Dₐ: Außendurchmesser
- Dₖ: Durchmesser
- H: Ringhöhe
- M: Abstand
- L: Löserichtung
- I: Innenwinkel
- d: Dicke
- F₁, F₂, Fₙ: Antriebskräfte (Zugkraft)
- G: Gegenkraft
- K₁, K₂, Kₙ: Lösemomente
- W, W': Biegungswinkel

## Patentansprüche

1. Biegsame Trägerhalterung (1) zur Halterung eines Trägersubstrats (13) beim Lösen des Trägersubstrats (13) von einem Produktsubstrat (11). wobei Lösemittel (1, 28) zum Ablösen des Produktsubstrats (11) unter Biegung des Trägersubstrats (13) vorgesehen sind, **dadurch gekennzeichnet, dass** die Trägerhalterung (1) eine Biegung des Trägersubstrats (13) zulassend und als Ring (3) mit verstellbarem Durchmesser (Dₖ) ausgebildet ist.

2. Vorrichtung zum Lösen eines Trägersubstrats (13) von einem Produktsubstrat (11) in einer Löserichtung (L) mit folgenden Merkmalen:
- einer in Löserichtung (L) biegsamen Trägerhalterung (1) gemäß Anspruch 1,
- einer Substrathalterung (18) zur Halterung des Produktsubstrats (11) und
- Lösemitteln (1, 15, 15', 16, 28) zum Ablösen des Trägersubstrats (13) vom Produktsubstrat (11) unter Biegung des Trägersubstrats (13).

3. Vorrichtung nach Anspruch 2, wobei die Trägerhalterung (1) in Löserichtung (L) elastisch verformbar ist.

4. Vorrichtung nach Anspruch 2 oder 3, bei der durch die Lösemittel (1, 15, 15', 16, 28) mindestens eine, insbesondere am Umfang der Substrathalterung (18) wirkende, Zugkraft (F₁, F₂, Fₙ) und mindestens eine entgegen der Zugkraft (F_{1,} F₂, Fₙ), insbesondere am Umfang der Trägerhalterung wirkende, Gegenkraft (G) zur Erzeugung von Lösemomenten (L₁, L₂, Lₙ) entlang einer Lösefront anlegbar sind.

5. Vorrichtung nach einem der Ansprüche 2 bis 4, bei der die Substrathalterung (18) als starre, insbesondere das Produktsubstrat (11) vollflächig aufnehmende, Substrathalterung (18) ausgebildet ist.

6. Trägerhalterung nach Anspruch 1, bei der die Trägerhalterung (1) als offener Ring (3) ausgebildet ist.

7. Trägerhalterung nach einem der Ansprüche 1 oder 6, die, insbesondere über den gesamten Ringumfang (3u) verlaufende, Haltemittel (9), insbesondere mit einer zurückspringenden Umfangsschulter (7), aufweist.

8. Trägerhalterung nach einem der Ansprüche 1, 6 oder 7, die das Trägersubstrat (13) im Wesentlichen vollständig seitlich umschließend ausgebildet ist.

9. Verfahren zum Lösen eines Trägersubstrats von einem Produktsubstrat in einer Löserichtung (L) mit folgenden Schritten, insbesondere folgendem Ablauf:
- Halterung des Produktsubstrats mit einer Substrathalterung und Halterung des Trägersubstrats mit einer in Löserichtung (L) biegsamen Trägerhalterung, die eine Biegung des Trägersubstrats zulassend und als Ring (3) mit verstellbarem Durchmesser (Dₖ) ausgebildet ist und
- Ablösen des Trägersubstrats vom Produktsubstrat unter Biegung des Trägersubstrats.

10. Verwendung einer biegsamen Trägerhalterung zur Halterung eines Trägersubstrats beim Ablösen des Trägersubstrats von einem Produktsubstrat, **dadurch gekennzeichnet, dass** die Trägerhalterung eine Biegung des Trägersubstrats zulassend und als Ring (3) mit verstellbarem Durchmesser (Dₖ) ausgebildet ist.

## Claims

1. Flexible carrier mount (1) for mounting of a carrier substrate (13) when the carrier substrate (13) is detached from a product substrate (11), detachment means (1, 28) being provided for debonding of the product substrate (11) with bending of the carrier substrate (13), **characterized in that** the carrier mount (1) is designed to allow bending of the carrier substrate (13) and made as an open ring (3) with an adjustable diameter (Dₖ).

2. Device for detaching a carrier substrate (13) from a product substrate (11) in one detachment direction (L) with the following features:
- a carrier mount (1) which is flexible in the detachment direction (L) for mounting of the carrier substrate (13),
- a substrate mount (18) for mounting of the product substrate (11) and
- detachment means (1, 15, 15', 16, 28) for debonding of the carrier substrate (13) from the product substrate (1) with bending of the carrier substrate (11), wherein the carrier mount (1) is designed to allow bending of the carrier substrate (13) and made as an open ring (3) with an adjustable diameter (Dₖ)..

3. Device as claimed in Claim 2, the carrier mount (1) being elastically deformable in the detachment direction (L).

4. Device as claimed in Claim 2 or 3, wherein at least one tensile force (F₁, F₂, Fₙ) acting especially on the periphery of the substrate mount (18) and at least one opposing force (G) acting against the tensile force (F₁, F₂, Fₙ), especially on the periphery of the carrier mount can be applied by the detachment means (1, 15, 15', 16, 28) to produce detachment moments (L₁, L₂, Lₙ) along one detachment front.

5. Device as claimed in one of Claims 2 to 4, wherein the substrate mount (18) is made as a rigid substrate mount (18) which accommodates the product substrate (11) over the entire surface.

6. Carrier mount as claimed in Claim 1, wherein the carrier mount (1) is made as an open ring (3).

7. Carrier mount as claimed in one of Claims 1 or 6, which has holding means (9) which run especially over the entire ring periphery (3u), especially with a rebounding peripheral shoulder (7).

8. Carrier mount as claimed in one of Claims 1, or 7, which is made to laterally enclose the carrier substrate (13) essentially completely.

9. Method for detaching a carrier substrate from a product substrate in one detachment direction (L) with the following steps, especially the following sequence:
- mounting of the product substrate with a substrate mount and mounting of the carrier substrate with a carrier mount which is flexible in the detachment direction (L) and which is designed to allow bending of the carrier substrate 813) and made as an open ring (3) with an adjustable diameter (Dₖ), and
- debonding of the carrier substrate from the product substrate with bending of the carrier substrate.

10. Use of a flexible carrier mount for mounting of a carrier substrate when the carrier substrate is debonded from a product substrate, **characterized in that** the carrier mount (1) is designed to allow bending of the carrier substrate (13) and made as an open ring (3) with an adjustable diameter (Dₖ).

## Revendications

1. Fixation porteuse (1) flexible destinée à fixer un substrat porteur (13) lors de la séparation du substrat porteur (13) d'un substrat de produit (11), sachant que des moyens de séparation (1, 28) pour séparer le substrat de produit (11) par flexion du substrat porteur (13) sont prévus, **caractérisé en ce que** la fixation porteuse (1) est formée de façon à permettre une flexion du substrat porteur (13) et en tant que bague (3) au diamètre (Dₖ) réglable.

2. Dispositif destiné à la séparation d'un substrat porteur (13) d'un substrat de produit (11) dans un sens de séparation (L), comprenant les caractéristiques suivantes :
- une fixation porteuse (1) selon la revendication 1, flexible dans le sens de séparation (L),
- une fixation de substrat (18) pour fixer le substrat de produit (1) et
- des moyens de séparation (1, 15, 15', 16, 28) pour séparer le substrat porteur (13) du substrat de produit (11) par flexion du substrat porteur (13).

3. Dispositif selon la revendication 2, dans lequel la fixation porteuse (1) peut être déformée élastiquement dans le sens de séparation (L).

4. Dispositif selon la revendication 2 ou 3, dans lequel, par les moyens de séparation (1, 15, 15', 16, 28), au moins une force de traction (F₁, F₂, Fₙ) agissant en particulier sur le pourtour de la fixation de substrat (18), et au moins une contre-force (G) agissant contre la force de traction (F₁, F₂, Fₙ), en particulier sur le pourtour de la fixation porteuse, peuvent être appliquées le long d'un front de séparation pour produire des couples de séparation (L₁, L₂, Lₙ).

5. Dispositif selon l'une des revendications 2 à 4, dans lequel la fixation de substrat (18) est formée en tant que fixation de substrat (18) fixe, recevant en particulier le substrat de produit (11) sur toute sa surface.

6. Fixation porteuse selon la revendication 1, dans laquelle la fixation porteuse (1) est formée en tant que bague (3) ouverte.

7. Fixation porteuse selon l'une des revendications 1 ou 6, qui présente des moyens de fixation (9) en particulier sur tout le pourtour (3u) de la bague, en particulier avec un épaulement périphérique en retrait (7).

8. Fixation porteuse selon l'une des revendications 1, 6 ou 7, qui est formée en entourant le substrat porteur (13) essentiellement latéralement et complètement.

9. Procédé de séparation d'un substrat porteur d'un substrat de produit dans un sens de séparation (L) comprenant les étapes suivantes, en particulier le déroulement suivant :
- fixation du substrat de produit avec une fixation de substrat et fixation du substrat porteur avec une fixation porteuse flexible dans le sens de séparation (L) qui est formée de façon à permettre une flexion du substrat porteur et en tant que bague (3) au diamètre (Dₖ) réglable et
- séparation du substrat porteur du substrat de produit par flexion du substrat porteur.

10. Emploi d'une fixation porteuse flexible pour fixer un substrat porteur lors de la séparation du substrat porteur d'un substrat de produit, **caractérisé en ce que** la fixation porteuse est formée de façon à permettre une flexion du substrat porteur et en tant que bague (3) au diamètre (Dₖ) réglable.
